Europäisches Patentamt

European Patent Office

Office européen des brevets

(11) Veröffentlichungsnummer: **0 381 109**
**A2**

## (12) EUROPÄISCHE PATENTANMELDUNG

(21) Anmeldenummer: **90101716.0**

(22) Anmeldetag: **29.01.90**

(51) Int. Cl.5: **H01L 23/29**

(30) Priorität: **01.02.89 DE 3902967**

(43) Veröffentlichungstag der Anmeldung:
**08.08.90 Patentblatt 90/32**

(84) Benannte Vertragsstaaten:
**BE CH DE ES FR GB IT LI NL SE**

(71) Anmelder: **Siemens Aktiengesellschaft**
**Wittelsbacherplatz 2**
**D-8000 München 2(DE)**

(72) Erfinder: **Birkle, Siegfried, Dr.**
**Veit-Stoss-Strasse 46**
**D-8552 Höchstadt/Aisch(DE)**
Erfinder: **Kammermaier, Johann, Dr.**
**Ziehrerstrasse 19**
**D-8025 Unterhaching(DE)**

(54) **Feuchtesperre für organische Dielektrika.**

(57) Hermetisch abdeckende und gut haftende Feuchtesperren für organische Dielektrika in integrierten Schaltungen, die auch eine einfache Strukturierung der Dielektrika erlauben, bestehen aus einer dünnen Schicht aus amorphem, wasserstoffhaltigem Kohlenstoff.

EP 0 381 109 A2

## Feuchtesperre für organische Dielektrika

Die Erfindung betrifft eine Feuchtesperre für organische Dielektrika in integrierten Schaltungen (ICs) sowie ein Verfahren zu deren Herstellung.

Beim Aufbau von Mehrlagenverschaltungen in hochintegrierten ICs ist es für deren Dauerfunktion von entscheidender Bedeutung, daß bei einer Klimabeanspruchung, vor allem bei Feuchte, insbesondere die dielektrischen Kennwerte der eingesetzten Dielektrika zeitstabil bleiben und daß die Aluminium-Leitbahnen nicht durch Korrosion geschädigt werden. Die Dielektrika dienen dabei, neben ihrer elektrischen Funktion, vor allem auch dazu, insbesondere bei Mehrlagenaufbauten - bei zunehmend steigendem Verhältnis von Strukturhöhe zu Breite - einebnend zu wirken, damit die nachfolgenden Aluminium-Schichten bzw. - Leitbahnen ohne Rißbildung aufgebaut werden können. Dielektrika der genannten Art müssen deshalb - bei zusätzlich einfacherer Strukturierbarkeit - gegen Feuchte geschützt werden.

Eines der derzeit bei integrierten Schaltungen meist verwendeten Dielektrika ist Polyimid, ein Kunststoff mit sehr guten thermischen, elektrischen und mechanischen Eigenschaften. Polyimid kann - zur Erzielung bestimmter Eigenschaften - chemisch vielseitig modifiziert werden und erfüllt auch in technologischer Hinsicht ein breites Anforderungsspektrum. Bedingt durch seine Molekülgrundstruktur, weist das Basismaterial Polyimid jedoch eine vergleichsweise hohe Wassersorption auf, aufgrund derer sich, vor allem bei Feuchtewechseln, die dielektrische Charakteristik unzulässig ändern kann. Dies gilt insbesondere für die Dielektrizitätszahl $\epsilon_r$ und den dielektrischen Verlustfaktor tan $\delta$.

Die Feuchteabhängigkeit der Dielektrizitätszahl und des Verlustfaktors von Polyimid zeigt sich anhand folgender Werte, die für eine relative Luftfeuchte (bei Raumtemperatur) von 0 % bzw. 100 % gelten: $\epsilon_r$: 3,32 bzw. 4,38; tan $\delta$ (1 kHz): $4,2.10^{-3}$ bzw. $15.10^{-3}$. Für die relative Feuchteempfindlichkeit der Dielektrizitätszahl und des Verlustfaktors von Polyimid gilt somit folgendes: Sie liegt für $\epsilon_r$ bei ca. 0,3 % pro Prozent relativer Feuchte und für tan $\delta$ bei ca. 2,6 % pro Prozent relativer Feuchte.

Zur Unterdrückung der bei Feuchtewechseln auftretenden dielektrischen Veränderungen bei der Verwendung von Polyimid-Dielektrika wird mit Hilfe einer kombinierten Technik die planarisierende dielektrische Polyimidschicht durch eine als Feuchtesperre wirkende anorganische Schutzschicht abgedeckt. Nach dem derzeitigen Stand der Technik dient als Material für diese Feuchtesperre meist Siliciumnitrid $Si_3N_4$, sogenanntes Plasmanitrid (siehe: Fachtagung "Polymerwerkstoffe für die Elektronik", 14.-16. Oktober 1987, Würzburg, Tagungsbericht (1987), Seiten 153 ff.).

Siliciumnitrid bzw. eine daraus hergestellte Feuchtesperre in Form einer Dünnschicht hat aber folgende Nachteile:

- Von der Materialseite her gesehen hat $Si_3N_4$ eine extrem niedrige Wasserdurchlässigkeit, die derjenigen von Metallen nahekommt. Da Schichten aus $Si_3N_4$ aber selbst bei einer Dicke unterhalb 0,25 $\mu$m sehr spröde sind, läßt sich bei der Aufbringung und der weiteren Verarbeitung derartiger Schichten die Bildung feiner Haarrisse nie ganz vermeiden, so daß - durch Kapillarwirkung und Kapillarkondensation - Wasser in erheblicher Menge durch die $Si_3N_4$-Schicht zum Polyimid gelangen kann.

- Vom ätzchemischen Standpunkt aus gesehen stellt mit $Si_3N_4$ abgedecktes Polyimid ein Zweilagensystem dar. Die Strukturierung dieses Zweilagensystems erfordert nun aber - aufgrund der Notwendigkeit des Einsatzes verschiedener Ätzmedien (beispielsweise $CF_4$ für $Si_3N_4$ und $O_2$ für Polyimid) - zwei unterschiedliche Ätzschritte. Dies kompliziert insbesondere die Herstellung von Mehrlagenaufbauten, erweist sich aber auch bereits bei zweilagigen Aluminium-Leitbahnsystemen als gravierender Nachteil.

Aufgabe der Erfindung ist es, eine hermetisch abdeckende, gut haftende Feuchtesperre für organische Dielektrika in integrierten Schaltungen anzugeben, die darüber hinaus eine Strukturierung des feuchtegeschützten Dielektrikums in technisch einfacher und zeitsparender Weise erlaubt.

Dies wird erfindungsgemäß dadurch erreicht, daß die Feuchtesperre aus einer dünnen Schicht aus amorphem, wasserstoffhaltigem Kohlenstoff (a-C:H) besteht.

Amorpher, wasserstoffhaltiger Kohlenstoff, kurz a-C:H, ist ein Kohlenstoffmaterial, bei dem ein amorphes Kohlenstoffnetzwerk vorliegt; aufgrund seiner mechanischen Härte wird dieses Kohlenstoffmaterial auch als diamantartiger Kohlenstoff bezeichnet (siehe beispielsweise: "IDR - Industrie Diamanten Rundschau", Bd. 18 (1984), Nr. 4, Seiten 249 ff.). Diese amorphe Modifikation von Kohlenstoff erhält ihre besonderen Eigenschaften, wie optische Transparenz, Mikrohärte, chemische Resistenz und elektrische Isolation, durch das Nebeneinander von tetraedrischer ($sp^3$-) und trigonaler ($sp^2$-) Hybridisierung sowie durch den Einbau von Wasserstoff (etwa 10 bis 40 Atom-%).

Die erfindungsgemäße Feuchtesperre in Form von a-C:H-Dünnschichten, die vorzugsweise eine Dicke etwa zwischen 0,05 und 3 $\mu$m aufweisen, erfüllt die an sie gestellten Forderungen in hohem Maße. Derartige Schichten sind nämlich aufgrund ihrer relativ hohen Dichte (bis 1,8 $g.cm^{-3}$) - selbst

in geringen Dicken unter 0,2 μm - als Feuchtesperre hochwirksam, zumal sie pinhole-frei sind und wegen ihrer amorphen Struktur keine molekularen Inhomogenitäten, wie Korngrenzen und dergleichen, enthalten. Dünnschichten aus a-C:H unterliegen auch keiner Rißbildung und sie sind deshalb als Feuchtesperre Schichten aus $Si_3N_4$ klar überlegen.

Die pinhole- und Rißfreiheit von a-C:H-Schichten bietet auch eine Gewähr dafür, daß beim Aufbringen von darüber anzuordnenden Aluminium-Leitbahnen keine Metallspitzen in die Dielektrikumsschicht eindringen können, so daß dadurch bedingte Isolationsschädigungen des Dielektrikums vermieden werden. Bei a-C:H-Schichten ist darüber hinaus von Vorteil, daß deren elektrischer Isolationswiderstand variabel einstellbar ist. Außerdem können beim Einsatz derartiger Schichten die organischen Dielektrika frei gewählt werden. Vorteilhaft bestehen die Dielektrika dabei aus Polyimid.

Die erfindungsgemäße Feuchtesperre weist ferner den Vorteil einer guten Haftung auf. Die Haftung von a-C:H-Schichten auf Polyimidschichten und Aluminiumflächen ist in der Regel so gut, daß Wasser in die Grenzflächen nicht lateral eindiffundieren kann. Somit können sich an diesen Stellen keine kondensierten Wasserfilme bilden.

Im Gegensatz dazu weist $Si_3N_4$, bedingt durch den Abscheideprozeß, nur eine begrenzte Haftfähigkeit mit Polyimidschichten auf. Aufgrund dieser Tatsache verbietet sich die Verwendung von $Si_3N_4$-Schichten mit einer Dicke über 0,25 μm, da vor allem in den Fällen, in denen durch eine Kunststoffumkapselung der Bausteine Feuchte durch Mikrorisse der $Si_3N_4$-Schicht zur Grenzfläche mit der Polyimidschicht gelangen kann, sich dort - bei ungenügender Haftung - kondensierte Wasserfilme bilden können.

Die hohe Feuchtesperrwirkung von a-C:H-Dünnschichten zeigt sich in folgendem. Eine Polyimidfolie mit einer Dicke von 128 μm weist gegenüber Wasser einen Permeationskoeffizienten von $2,14.10^{-10}$ $m^2.s^{-1}$ auf. Wird diese Folie mit einer 0,9 μm dicken a-C:H-Schicht beschichtet, so vermindert sich der Permeationskoeffizient auf $5,7.10^{-11}$ $m^2.s^{-1}$. Daraus ergibt sich für die a-C:H-Schicht ein $H_2O$-Permeationskoeffizient von $1,1.10^{-13}$ $m^2.s^{-1}$, der unter den Meßdaten bekannter feuchtehemmender Schichten einen extrem niedrigen Wert darstellt.

Ein weiterer Vorteil des Zweischichtensystems aus einem Dielektrikum und der erfindungsgemäßen Feuchtesperre für die IC-Technologie besteht darin, daß damit - im Vergleich zu Aufbauten mit konventionellen Feuchtesperren - eine prozeßstufenreduzierte Strukturierung möglich ist. Dies liegt darin begründet, daß bei der Strukturierung von mit a-C:H abgedecktem Polyimid oder einem anderen organischen Dielektrikum nur ein Ätzschritt erforderlich ist, nämlich $O_2$-RIE, während beim Vorhandensein anderer anorganischer Feuchtesperren, wie $Si_3N_4$, ein zusätzlicher Ätzschritt mit $CF_4$ oder dergleichen notwendig ist.

Als Ätzmaske bei der $O_2$-RIE-Strukturierung von a-C:H-bedecktem Polyimid dient eine siliciumhaltige Photoresistschicht, mit der sich feinere Strukturen erzeugen lassen als dies mit konventionellen Photolacken der Fall ist. In einem ersten Verfahrensschritt wird dabei der Photolack strukturiert. Nach dem Stand der Technik muß dann in einem zweiten Verfahrensschritt die anorganische Feuchtesperre geätzt werden (mittels $CF_4$-RIE oder dergleichen) und anschließend - in einem dritten Schritt - die organische Dielektrikumsschicht (mittels $O_2$-RIE). Beim Vorhandensein einer erfindungsgemäßen Feuchtesperre erfolgt dagegen nach der Strukturierung des Photolackes lediglich ein zweiter Verfahrensschritt, nämlich das gleichzeitige Ätzen der a-C:H-Schicht und der organischen Dielektrikumsschicht (mittels $O_2$-RIE). Die Verwendung der erfindungsgemäßen Feuchtesperre bringt somit bei der Strukturierung des organischen Dielektrikums - im Vergleich zur derzeitigen Technik - eine Verminderung der Verfahrensschritte um ein Drittel pro Leitbahnebene mit sich.

Die Herstellung der erfindungsgemäßen Feuchtesperre erfolgt in der Weise, daß auf eine Schicht oder Folie aus einem organischen Dielektrikum durch eine Hochfrequenz-Niederdruck-Plasmaabscheidung gasförmiger Kohlenwasserstoffe eine dünne Schicht aus amorphem, wasserstoffhaltigem Kohlenstoff aufgebracht wird. Die Plasmaabscheidung erfolgt dabei vorzugsweise mittels Radiofrequenz (RF), d.h. im Bereich zwischen 0,1 und 100 MHz, sie kann aber auch mittels Mikrowellen (MW) erfolgen, d.h. im Bereich zwischen 0,1 und 1000 GHz.

Als gasförmige Kohlenwasserstoffe dienen bei der Herstellung der erfindungsgemäßen Feuchtesperre vorteilhaft Alkane, d.h. gesättigte aliphatische Kohlenwasserstoffe, wie Methan, Ethan und Propan; dabei wird Methan bevorzugt. Daneben können aber auch Alkene, d.h. ungesättigte aliphatische Kohlenwasserstoffe, wie Ethen und Propen, eingesetzt werden, sowie Acetylen, Cycloalkane, d.h. gesättigte cyclische Kohlenwasserstoffe, wie Cyclohexan, und - im dampfförmigen Zustand - aromatische Kohlenwasserstoffe in Form von Benzol und Benzolderivaten. Die Kohlenwasserstoffe der vorstehend genannten Art können einzeln oder im Gemisch zum Einsatz gelangen. Den Kohlenwasserstoffen können ferner Wasserstoff und/oder Edelgase, wie Helium und Argon, zugegeben werden.

In Hochfrequenzentladungen, insbesondere mit RF-Anregung, bildet sich bei unterschiedlich gro-

3

ßen Innenelektroden der Entladungseinrichtung (Flächenverhältnis ≤ 0,5, vorzugsweise zwischen 0,25 und 0,05) - aufgrund von Raumladungen - eine im Takt der Hochfrequenz (HF) pulsierende Gleichstrom-Spannungskomponente (Vorspannung bzw. "self bias potential") bis zu etwa 1 kV aus. Diese DC-Spannungskomponente überlagert sich der HF-Wechselspannung und macht die kleinere Elektrode zur Kathode. Dadurch werden die geladenen $C_xH_y$-Teilchen, die durch Ionisierung und Fragmentierung des Reaktionsgases entstehen, zur Kathode hin beschleunigt und auf dem vor der Kathode angeordneten Substrat mit hoher kinetischer Energie - unter Bildung von a-C:H-abgeschieden. Ein "self bias"-Effekt der vorstehend genannten Art ist, wenngleich - wegen des Fehlens von Innenelektroden -in sehr viel geringerem Ausmaß, auch bei MW-induzierten Abscheideplasmen wirksam, weil zwischen Plasma und Substratfläche in jedem Fall eine Potentialdifferenz besteht.

Anhand eines Ausführungsbeispiels wird die Erfindung noch näher erläutert.

In eine Apparatur zur Plasmaabscheidung von a-C:H mittels RF-Anregung in Form eines zylindrischen Glasgefäßes wird Methan $CH_4$ (als Reaktionsgas) bei einem Druck von 100 Pa eingeleitet. Das Reaktionsgas gelangt in das sich zwischen zwei ungleichen Elektroden (Flächenverhältnis 1:4) ausbildende Plasma mit einem Volumen von ca. 400 cm³. Die beiden Elektroden sind mit einem RF-Generator verbunden ($\gamma$ = 13,56 MHz). Aufgrund der ungleichen Elektroden entsteht zwischen diesen eine - sich der RF-Spannung überlagernde - self bias-DC-Spannung, wobei die kleinere Elektrode, welche die zu beschichtenden Substrate, d.h. die Dielektrika, trägt, zur Kathode wird.

Bei einer Hochfrequenz-Leistungsdichte von ca. 2,2 $W.cm^{-2}$, bezogen auf die Kathodenfläche, entsteht zwischen den beiden Elektroden eine self bias-DC-Spannung von ca. 500 V. Unter diesen Bedingungen erhält man bei einem $CH_4$-Massedurchfluß von $8,8.10^4$ $Pa.cm^3.s^{-1}$ auf einer Polyimidfolie nach 10 min (Abscheiderate: ca. 1,7 $nm.s^{-1}$) eine ca. 1 um dicke a-C:H-Schicht mit einem $H_2O$-Permeationskoeffizienten von $1,1.10^{-13}$ $m^2.s^{-1}$.

## Ansprüche

1. Feuchtesperre für organische Dielektrika in integrierten Schaltungen, **dadurch gekennzeichnet,** daß sie aus einer dünnen Schicht aus amorphem, wasserstoffhaltigem Kohlenstoff (a-C:H) besteht.

2. Feuchtesperre nach Anspruch 1, **dadurch gekennzeichnet,** daß sie eine Dicke etwa zwischen 0,05 und 3 μm aufweist.

3. Feuchtesperre nach Anspruch 1 oder 2, **dadurch gekennzeichnet,** daß die organischen Dielektrika aus Polyimid bestehen.

4. Verfahren zur Herstellung einer Feuchtesperre nach einem der Ansprüche 1 bis 3, **dadurch gekennzeichnet,** daß auf eine Schicht oder Folie aus einem organischen Dielektrikum durch eine Hochfrequenz-Niederdruck-Plasmaabscheidung gasförmiger Kohlenwasserstoffe eine dünne Schicht aus amorphem, wasserstoffhaltigem Kohlenstoff aufgebracht wird.

5. Verfahren nach Anspruch 4, **dadurch gekennzeichnet,** daß die Plasmaabscheidung mittels Radio-Frequenz erfolgt.

6. Verfahren nach Anspruch 4 oder 5, **dadurch gekennzeichnet,** daß als Kohlenwasserstoffe Alkane eingesetzt werden, insbesondere Methan.